# EUROPÄISCHE PATENTSCHRIFT

(11) **EP 3 611 535 B1**
(45) Veröffentlichungstag und Bekanntmachung des Hinweises auf die Patenterteilung: **14.07.2021**
(21) Anmeldenummer: 19187266.2
(22) Anmeldetag: 19.07.2019
(51) Int. Cl.: G01S 7/4863, G01S 7/4865, G01S 7/487, G01S 7/497, G01S 17/10, G01S 17/894, G01J 1/44, H01L 31/02, G01S 17/18, G01S 17/42

(54) **ERFASSEN VON LICHT MIT EINER VIELZAHL VON LAWINENPHOTODIODENELEMENTEN**
DETECTION OF LIGHT WITH A PLURALITY OF AVALANCHE PHOTODIODE ELEMENTS
CAPTURE DE LUMIÈRE À L'AIDE D'UNE PLURALITÉ D'ÉLÉMENTS DE PHOTODIODE À AVALANCHE

(30) Priorität: 17.08.2018 DE 102018120141
(43) Veröffentlichungstag der Anmeldung: 19.02.2020
(73) Patentinhaber: SICK AG, 79183 Waldkirch (DE)
(72) Erfinder: Steinkogler, Dr. Sascha, 79106 Freiburg (DE); Marra, Martin, 79280 Au (DE); Clemens, Klaus, 79367 Weisweil (DE)

(56) Entgegenhaltungen:
- EP-A1- 3 339 887
- DE-A1-102014 207 599

## Beschreibung

Die Erfindung betrifft einen Lichtempfänger und ein Verfahren zum Erfassen von Licht mit einer Vielzahl von Lawinenphotodiodenelementen nach dem Oberbegriff von Anspruch 1 beziehungsweise 9.

Ein Lichtempfänger hat die Funktion, aus einfallendem Empfangslicht ein elektrisches Signal zu erzeugen. Die Nachweisempfindlichkeit einfacher Photodioden genügt in vielen Anwendungsfällen nicht. In einer Lawinenphotodiode (APD, Avalanche Photo Diode) löst das einfallende Licht einen kontrollierten Lawinendurchbruch (Avalanche Effect) aus. So werden die von einfallenden Photonen erzeugten Ladungsträger vervielfacht, und es entsteht ein Photostrom, der zu der Lichtempfangsintensität proportional, dabei aber wesentlich größer ist, als bei einer einfachen PIN-Diode. Im sogenannten Geiger-Modus ist die Lawinenphotodiode oberhalb der Durchbruchspannung (Breakdownvoltage) vorgespannt (Bias), so dass bereits ein einziger, durch ein einzelnes Photon freigesetzter Ladungsträger eine Lawine auslösen kann, die dann aufgrund der hohen Feldstärke sämtliche verfügbaren Ladungsträger rekrutiert. Die Lawinenphotodiode zählt somit, wie der namensgebende Geigerzähler, Einzelereignisse. Lawinenphotodioden im Geiger-Modus werden auch als SPADs (Single-Photon Avalanche Diode) bezeichnet.

Geiger-APDS oder SPADs sind also sehr schnelle, hochempfindliche Photodioden auf Halbleiterbasis. Ein Nachteil der hohen Empfindlichkeit ist, dass nicht nur ein Nutzlichtphoton, sondern auch ein schwaches Störereignis durch Fremdlicht, optisches Übersprechen oder Dunkelrauschen den Lawinendurchbruch auslösen kann. Dieses Störereignis trägt dann mit dem gleichen relativ starken Signal zum Messergebnis bei wie das empfangene Nutzlicht und ist davon auch aus dem Signal heraus nicht unterscheidbar. Anschließend ist die Empfindlichkeit der Lawinenphotodiode für eine Tot- oder Erholungszeit von ca. 5 bis 100 ns drastisch reduziert, so dass sie solange für weitere Messungen praktisch ausfällt. Deshalb ist es üblich, mehrere SPADs statistisch auszuwerten. Ein typischer Silizium-Photomultiplier (SiPM) mit SPADs weist mehrere tausend SPADs auf.

Lichtempfänger mit SPADs eignen sich auch für die Lichtlaufzeitmessung (TOF, Time of Flight) zur Abstandsmessung mit Laserpulsen. Dabei wird beispielsweise ein TDC (Time-to-Digital Converter) zu einem Sendezeitpunkt des Laserpulses gestartet und mit Empfang des Laserpulses nach Reflexion von einem Zielobjekt wieder angehalten. Der beschriebene Totzeiteffekt kann beispielsweise bei höheren Temperaturen mit vielen Dunkelereignissen ohne Lichtempfang beziehungsweise bei viel Fremdlichteinstrahlung die Messfähigkeit beeinträchtigen. Jedenfalls sollte das bei der Bestimmung eines Empfangszeitpunktes berücksichtigt werden, weil sich der Messwert andernfalls verfälscht, besonders wenn die Anzahl der vom Zielobjekt zurückreflektierten Photonen innerhalb der Erholungszeit erheblich die Gesamtpixelzahl überschreitet.

Der Stand der Technik liefert aber dafür keine befriedigende Lösung. Die EP 2 708 914 A1 offenbart einen SPAD-basierten Sensor zur Aufnahme einer Tiefenkarte, bei dem ein durch einen MEMS-Spiegel abgelenkter Sendelichtstrahl die Szene abtastet. Es sind jeweils nur die SPADs aktiv, auf die der mit dem Sendestrahl beleuchtete Bereich der Szene abgebildet wird. Das dient einer Ortsauflösung durch Abtastung, verbessert aber die jeweilige Abstandsmessung am angetasteten Ort in keiner Weise.

Aus der EP 3 270 182 A1 ist ein weiterer Sensor mit Lawinenphotodioden im Geiger-Modus bekannt. Deren Empfindlichkeit wird über die Vorspannung dynamisch angepasst. In einer Ausführungsform wird die Empfindlichkeit anfangs gering eingestellt und dann entsprechend der Ausbreitungsgeschwindigkeit von Licht erhöht. Damit erhöht sich zwar die Wahrscheinlichkeit, dass wegen der zunächst geringeren Empfindlichkeit auch bei einem Echo von einem fernen Objekt Lawinenphotodioden verfügbar sind, die noch nicht ausgelöst haben. Bei ungünstigen Bedingungen beispielsweise mit viel Fremdlicht reicht diese Maßnahme aber nicht aus, und Verfälschungen des Messwerts durch Effekte der Totzeiten bleiben gänzlich unberücksichtigt.

In der EP 3 339 887 A1 wird eine sogenannte elektronische Blende für einen SPAD-basierten Lichtempfänger vorgeschlagen. Durch über den Lichtempfänger unterschiedliche Anpassung der Vorspannung oder Unterdrückung der Signale bestimmter SPADs beim Auslesen, sorgt die elektronische Blende für eine Ortsverteilung der Empfindlichkeit. Als ein beispielhaftes Muster wird ein Schachbrett mit alternierend aktiven und inaktiven SPADs vorgeschlagen. Dieses Muster bleibt dann fixiert, und es wird nicht weiter diskutiert, welchen Nutzen dieses Muster hat.

Die DE 10 2014 207 599 A1 offenbart einen Photodetektor mit mehreren Lawinenphotodioden pro Bildpunkt, die reihum zeitversetzt zueinander aktiviert werden. Die einzelne aktive Zeitdauer ist kleiner als die Regenerationszeit, in Summe über die Lawinenphotodioden eines Bildpunktes sind die Zeitdauern aber größer als die Regenerationszeit, so dass ein kontinuierlicher Betrieb ermöglicht wird. Dazu ist aber eine große Anzahl von Lawinenphotodioden pro Bildpunkt erforderlich. Außerdem ist die Aktivierungsabfolge für alle Bildpunkte gleich, so dass keine Flexibilität in der Ortsverteilung der jeweils aktiven Lawinenphotodioden bleibt.

Es ist daher Aufgabe der Erfindung, die Anpassung der Lawinenphotodioden an eine Messung zu verbessern.

Diese Aufgabe wird durch einen Lichtempfänger und ein Verfahren zum Erfassen von Licht mit einer Vielzahl von Lawinenphotodiodenelementen nach Anspruch 1 beziehungsweise 9 gelöst. Wird an die Lawinenphotodiodenelemente eine Vorspannung (Biasspannung) oberhalb der Durchbruchspannung angelegt, so arbeiten sie im Geiger-Modus. Die Lawinenphotodiodenelemente sind zu Gruppen zusammengefasst, wobei die Lawinenphotodiodenelemente einer Gruppe insbesondere musterartig über den Lichtempfänger verteilt sind.

Die Erfindung geht von dem Grundgedanken aus, die Empfindlichkeiten der Gruppen in einer zeitlichen Abfolge zu verstellen. Damit kommt zu der örtlichen Verteilung mittels der Gruppen eine zeitliche Verteilung hinzu. Diese Empfindlichkeit kann durch die Schaltung vorgegeben sein, etwa durch Widerstandswerte, Kapazitäten und dergleichen in der Verschaltung der Lawinenphotodioden. Die Veränderung der Empfindlichkeit schließt vorzugsweise den Extremfall eines Aktivierens beziehungsweise Deaktivierens ein, insbesondere in der Form, dass zwischen dem linearen Modus und dem Geiger-Modus gewechselt wird. Dazwischen liegt ein Faktor 10⁵-10⁶ in der Empfindlichkeit, was einem Aktivieren und Deaktivieren gleichkommt.

Jeweils zwei Lawinenphotodioden aus zwei unterschiedlichen Gruppen bilden eine mindestens duale Lawinenphotodiode mit mindestens einer vorderen Lawinenphotodiode und einer hinteren Lawinenphotodiode, bei der ein Lawinendurchbruch der vorderen Lawinenphotodiode die Empfindlichkeit der hinteren Lawinenphotodiode verändert. Die Begriffe vordere und hintere Lawinenphotodiode dienen nur der begrifflichen Unterscheidbarkeit und orientieren sich an einer bevorzugten zeitlichen Abfolge. Tatsächlich können beide Lawinenphotodioden identisch aufgebaut sein beziehungsweise die Rollen tauschen. In der dualen Lawinenphotodiode wird der Zeitpunkt, zu dem die hintere Lawinenphotodiode aktiv wird, automatisch durch das Auslösen der vorderen Lawinenphotodiode gesteuert. Besonders bevorzugt sorgt der Lawinendurchbruch der vorderen Lawinenphotodiode für eine veränderte Vorspannung an der hinteren Lawinenphotodiode. Dabei sind Veränderungen in beide Richtungen, also ein Anheben und Absenken denkbar, und diese Veränderung kann die Empfindlichkeit mittels angepasster Überspannung graduell einstellen oder die Schwelle der Durchbruchspannung kreuzen und somit die hintere Lawinenphotodiode effektiv aktivieren oder deaktivieren.

Die Erfindung hat den Vorteil, dass eine hohe Flexibilität und Anpassbarkeit an Messanforderungen erreicht wird. Dazu werden Gruppen von Lawinenphotodioden geeignet über die Fläche verteilt, und deren Empfindlichkeit wird in bestimmter zeitlicher Abfolge angepasst. Das lässt sich insbesondere für Lichtlaufzeitmessungen optimieren, um Messfehler durch eine Schwarz-Weiß-Verschiebung effizient und kostengünstig zu korrigieren oder zu vermeiden. Außerdem werden zugunsten eines verbesserten Signal-Rauschverhältnisses und einer geringeren Leistungsaufnahme die Dunkelauslöser reduziert, beispielsweise ungefähr auf die Hälfte im Falle zweier Gruppen, die alternierend aktiv sind.

Die sequentielle Schaltung einer mindestens dualen Lawinenphotodiode hat eine Reihe von Vorteilen. Sie bewirkt eine Unterdrückung von Pixelübersprechen. Es können defekte Lawinenphotodioden, die fehlerhaft auslösen, unterdrückt werden, indem die intakte Lawinenphotodiode mit einer höheren Überspannung und die defekte Lawinenphotodiode nur mit der Durchbruchspannung betrieben wird. Ein Löschwiderstand, der für das Erlöschen der Lawine bei einem Detektionsereignis zuständig ist, kann reduziert und so ein höheres Ausgangssignal erreicht werden. Speziell durch Reihenschaltung von vorderer und hinterer Lawinenphotodiode kann die Ausgangskapazität des Lichtempfängers auf ein Viertel reduziert werden: Es werden n Zellen mit n parallelgeschalteten Kapazitäten durch n/2 duale Zellen mit jeweils halber Kapazität ersetzt. Es ist möglich, das Konzept der dualen Zellen auf k-fach-Lawinenphotodioden mit einer Kette von k Lawinenphotodioden zu erweitern, wobei dann jeweils eine Lawine in einer Lawinenphotodiode die Empfindlichkeit der in der Kette nachfolgenden Lawinenphotodiode verändert. Die Umschaltung zwischen den beiden Lawinenphotodioden kann elektrisch störungsfrei erfolgen, also ohne beim Schaltvorgang Störsignale zu erzeugen. Der Schaltungsaufwand für die separate Ansteuerung der zweiten Lawinenphotodiode ist minimal und bedarf beispielsweise lediglich eines Kopplungswiderstands. Die Tot- oder Erholungszeit kann durch die Wahl von Kopplungswiderstand und Kapazitäten beeinflusst und kontrolliert werden. Durch Reduktion der Anzahl gleichzeitig aktiver benachbarter Lawinenphotodioden lässt sich das elektrische und optische Übersprechen reduzieren.

Der dualen Lawinenphotodiode ist eine Verschaltungseinheit zugeordnet, welche im Ruhezustand vor einem Lawinendurchbruch die vordere Lawinenphotodiode auf eine Vorspannung über und die hintere Lawinenphotodiode auf eine Vorspannung unter der Durchbruchspannung hält. Dazu ist insbesondere eine Spannungsteilerschaltung vorgesehen, die eine sehr einfache und kostengünstige Umsetzungsmöglichkeit darstellt. Sie verteilt asymmetrisch eine Gesamtspannung, die in der Größenordnung des Doppelten der Durchbruchspannung liegt. Im Ruhezustand ist nur die vordere Lawinenphotodiode oberhalb der Durchbruchspannung versorgt und damit aktiv. Bei einem Lawinendurchbruch wird sie niederohmig, so dass nun an der hinteren Lawinenphotodiode eine höhere Spannung anliegt, die sie über die Durchbruchspannung und damit in den Geiger-Modus bringt und so aktiviert.

Alternativ sind Gesamtspannung und Verhältnis so, dass vordere und hintere Lawinenphotodiode mit unterschiedlichen Überspannungen versorgt sind und sich daher graduell in ihrer Empfindlichkeit unterscheiden, wobei ein Lawinendurchbruch das Verhältnis der Empfindlichkeiten verändert. In einer weiteren Ausführungsform sorgt der Lawinendurchbruch in der einen Lawinenphotodiode nicht für ein Aktivieren, sondern umgekehrt für ein Deaktivieren der anderen Lawinenphotodiode, deren Vorspannung unter die Durchbruchspannung gedrückt wird. So sind im Ruhezustand beide Lawinenphotodioden aktiv. Bei einem starken Empfangssignal unterdrückt eine empfangende Lawinenphotodiode ein Empfangssignal ihres Partners. Das verhindert ein Übersteuern, und die zweite Lawinenphotodiode steht, sobald ihre Vorspannung direkt nach dem Lawinenereignis in der empfangenden Lawinenphotodiode wieder über die Durchbruchspannung steigt, ohne Erholungszeit zum Aufladen für eine weitere Detektion zur Verfügung.

Die Spannungsteiler und damit die jeweils anliegenden Spannungen können je dualer Lawinenphotodiode, aber auch parallel verschaltet für mehrere Lawinenphotodioden vorgesehen sein, insbesondere eine Zeile oder Spalte vorgesehen sein. Das Teilungsverhältnis kann durch die Schaltelemente fixiert oder einstellbar sein.

Bei Erhöhen der Vorspannung über die Durchbruchspannung werden Lawinenphotodiodenelemente aktiviert und/oder durch Absenken der Vorspannung unter die Durchbruchspannung deaktiviert. Die Empfindlichkeit wird so nicht nur graduell verändert, sondern das jeweilige Lawinenphotodiodenelement durch Wechsel zwischen dem linearen Modus (APD-Modus) und dem Geiger-Modus aktiviert und/oder deaktiviert.

Die Durchbruchspannung ist die minimale benötigte Vorspannung für den Geiger-Modus. Genaugenommen sind jedoch bei diesem Grenzwert die Photonen-Detektions-Effizienz (PDE) und die Verstärkung immer noch Null. Erst wenn die Vorspannung die Durchbruchspannung übersteigt, werden einfallende Photonen in entsprechende Geigerstromimpulse umgesetzt, wobei die Auslösewahrscheinlichkeit mit der Überspannung ansteigt. Somit wird mittels unterschiedlicher Überspannungen eine graduelle Empfindlichkeitssteuerung mit unterschiedlichen Empfindlichkeiten der Gruppen erreicht. Es ist auch denkbar, derselben Gruppe zu zwei unterschiedlichen Zeitpunkten unterschiedliche Überspannungen und damit Empfindlichkeiten zu verleihen.

Vorzugsweise ist eine Lichtlaufzeitmesseinheit vorgesehen, die dafür ausgebildet ist, aus den Signalen der Lawinenphotodiodenelemente eine Lichtlaufzeit eines Lichtpulses zu bestimmen. Vorzugsweise wird dazu ein aus den Signalen abgeleiteter Empfangszeitpunkt mit einem optisch oder elektrisch gewonnenen Referenzzeitpunkt der Aussendung des Lichtpulses verglichen, beispielsweise mittels TDCs. Da in einer einzelnen Lawinenphotodiode im Geiger-Modus ein Messereignis und ein Störereignis nicht unterscheidbar sind, werden bevorzugt statistische Verfahren über eine Vielzahl von Lawinenphotodioden beziehungsweise Messwiederholungen eingesetzt.

Die Lawinenphotodiodenelemente bilden vorzugsweise eine Matrixanordnung, wobei in einer Unterteilung der Matrixanordnung in ein Raster aus Rasterelementen jede Gruppe mindestens ein Lawinenphotodiodenelement in jedem Rasterelement aufweist. Dabei wird eine Matrixanordnung von n x m Lawinenphotodioden in ein Raster aus einer Vielzahl von Rasterelementen mit i x j Lawinenphotodioden unterteilt. In jedem Rasterelement befindet sich zumindest eine Lawinenphotodiode aus jeder Gruppe. Damit ergibt sich eine über den Lichtempfänger vergleichbare Empfindlichkeit.

Die Lawinenphotodiodenelemente zweier Gruppen bilden bevorzugt ein Schachbrettmuster. Dabei sind verschiedene Körnungen denkbar, in denen jeweils Bereiche mit k Lawinenphotodioden zum selben Musterelement des Schachbretts gehören. Das Schachbrettmuster lässt sich als Spezialfall eines Rasters aus Rasterelementen mit zwei Gruppen auffassen, mit der Zusatzbedingung, dass sich in jeweils benachbarten Rasterelementen die Reihenfolge der Einstellung der Empfindlichkeiten der Lawinenphotodioden umkehrt.

Vorzugsweise ist eine Verzögerungsschaltung vorgesehen, welche nach einem Lawinendurchbruch in der vorderen Lawinenphotodiode die hintere Lawinenphotodiode nach einer vorgebbaren Verzögerungszeit aktiviert oder deaktiviert. Die Verzögerungszeit kann durch Elemente der Verzögerungsschaltung festgelegt sein, oder sie ist durch eine Ansteuerung einstellbar. Die Wahl des Verhältnisses eines Spannungsteilers ist eine Möglichkeit, die Verzögerungszeit über den benötigten Spannungsunterschied für ein Kreuzen der Vorspannung zu beeinflussen.

In vorteilhafter Weiterbildung ist ein optoelektronischer Sensor mit mindestens einem erfindungsgemäßen Lichtempfänger vorgesehen, wobei der Sensor zur Entfernungsmessung und/oder als Codeleser und/oder zur Datenübertragung ausgebildet ist. Die Entfernung kann durch Triangulation bestimmt werden, wie in einem Triangulationstaster oder einer Stereokamera. Weitere nicht abschließende Anwendungen des Lichtempfängers in einem optoelektronischen Sensor sind Codelesen oder Datenübertragung oder Kombinationen dieser Anwendungen in einem Sensor.

Der Sensor ist besonders bevorzugt ein entfernungsmessender Sensor mit einem Lichtsender zum Aussenden eines Lichtsignals und mit einer Lichtlaufzeitmesseinheit, die dafür ausgebildet ist, aus einer Lichtlaufzeit zwischen Aussenden des Lichtsignals und Empfangen des von dem Objekt aus dem Überwachungsbereich remittierten Lichtsignals einen Abstand des Objekts zu bestimmen. Das Lichtsignal weist bevorzugt einen Lichtpuls auf, und der Sensor misst Entfernungen nach dem Pulsverfahren. Dabei sind auch kompliziertere Formen wie Doppelpulse oder sogar Pulscodes denkbar. Es können auch mehrere Lichtpulse nacheinander ausgesandt, empfangen und die jeweiligen Einzelergebnisse gemeinsam statistisch ausgewertet werden, etwa in einem Pulsmittelungsverfahren. Das Lichtlaufzeitverfahren kann in einem eindimensionalen Entfernungstaster, einem Laserscanner oder einem Bildsensor einer 3D-Kamera nach dem Lichtlaufzeitprinzip genutzt werden.

Das erfindungsgemäße Verfahren kann auf ähnliche Weise weitergebildet werden und zeigt dabei ähnliche Vorteile. Derartige vorteilhafte Merkmale sind beispielhaft, aber nicht abschließend in den sich an die unabhängigen Ansprüche anschließenden Unteransprüchen beschrieben.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine schematische Darstellung eines optoelektronischen Sensors mit einem Lichtempfänger mit einer Vielzahl von Lawinenphotodiodenelementen im Geiger-Modus;
- Fig. 2: Darstellungen eines aufgrund von Totzeiten nur teilweise erfassten Empfangspulses;
- Fig. 3: eine schematische Darstellung einer alternierenden zeitlichen Aktivierung von Lawinenphotodiodenelementen in einer Art Schachbrettmuster;
- Fig. 4: eine Darstellung eines Empfangspulses, der durch nacheinander aktivierte Gruppen von Lawinenphotodiodenelementen vollständig erfasst werden kann;
- Fig. 5: eine schematische Darstellung einer Rastereinteilung von Gruppen von Lawinenphotodiodenelementen mit sequentieller Aktivierung;
- Fig. 6: Beispiele anderer Muster von nacheinander aktiven Lawinenphotodiodenelementen;
- Fig. 7: eine schematische Schaltungsdarstellung einer dualen Lawinenphotodiode mit zwei Lawinenphotodiodenelementen, in denen ein Lawinendurchbruch in dem einen Lawinenphotodiodenelement die Empfindlichkeit des anderen Lawinenphotodiodenelements verändert;
- Fig. 8: eine Darstellung einer alternierenden zeitlichen Aktivierung in einer Art Schachbrettmuster ähnlich Figur 3, jedoch mit dualen Lawinenphotodioden gemäß Figur 7; und
- Figur 9: eine schematische Darstellung mehrerer parallel mit einem Spannungsteiler verbundener dualer Lawinenphotodioden.

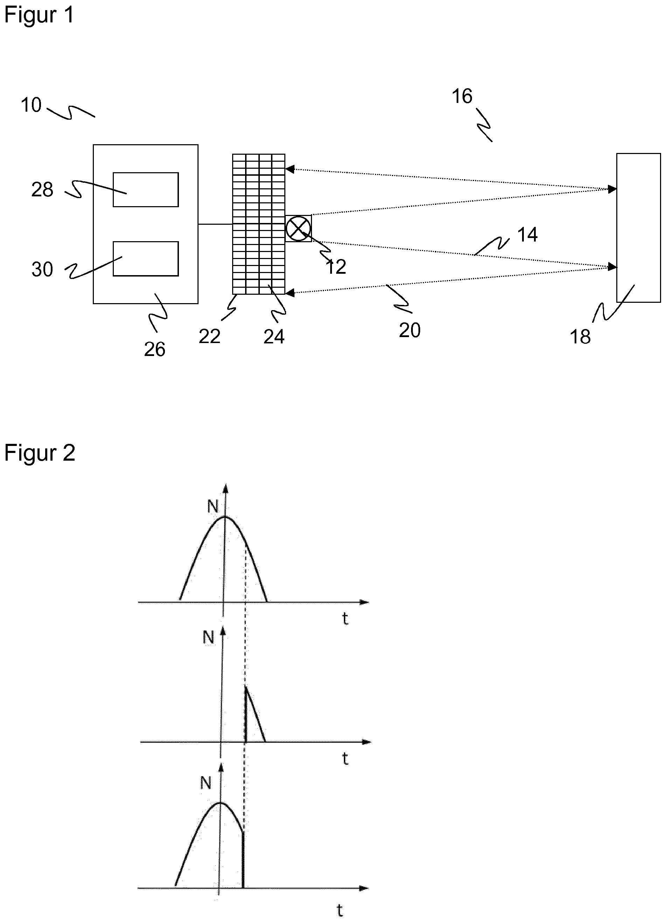

Figur 1 zeigt eine schematische Darstellung eines optoelektronischen Sensors 10 in einer Ausführungsform als einstrahliger Lichttaster. Ein Lichtsender 12, beispielsweise eine LED oder eine Laserlichtquelle, sendet ein Lichtsignal 14 in einen Überwachungsbereich 16 aus. Trifft es dort auf ein Objekt 18, so wird ein Teil des Lichtsignals remittiert oder reflektiert und kehrt als remittiertes Lichtsignal 20 zu einem Lichtempfänger 22 zurück. Dieser Lichtempfänger 22 umfasst eine Vielzahl von Lawinenphotodiodenelementen 24 im Geiger-Modus oder SPADs. Die Empfangssignale der Lawinenphotodiodenelemente 24 werden von einer Steuer- und Auswertungseinheit 26 ausgelesen und dort ausgewertet.

In der Darstellung werden nur ganz schematisch und auf rein funktionaler Ebene zwei Blöcke der Steuer- und Auswertungseinheit 26 hervorgehoben, nämlich eine Lichtlaufzeitmesseinheit 28 und eine Ansteuereinheit 30. Die Lichtlaufzeitmesseinheit 28 misst eine Lichtlaufzeit vom Aussenden des Lichtsignals 14 bis zum Empfang des remittierten Lichtsignals 20 und rechnet dies über die Lichtgeschwindigkeit in einen Abstand um. Die Lichtlaufzeitmesseinheit 28 ist nicht vorhanden, wenn der Sensor 10 eine andere Aufgabe hat, als eine Abstandsbestimmung mit einem Lichtlaufzeitverfahren. Die Ansteuereinheit 30 ist in der Lage, die Empfindlichkeit der Lawinenphotodiodenelemente 24 gruppenweise zu verändern, wie weiter unten noch detailliert erläutert wird.

Der Sensor 10 weist in einer praktischen Ausführungsform weitere Elemente auf, insbesondere Sende- und Empfangsoptiken und Anschlüsse, auf die hier vereinfachend nicht eingegangen wird. Die Auftrennung in Lichtempfänger 22 und Steuer- und Auswertungseinheit 26 in Figur 1 ist auch in der Praxis denkbar, dient aber in erster Linie der Erläuterung. Vorzugsweise werden diese Elemente zumindest teilweise auf einem gemeinsamen Chip integriert, dessen Fläche sich lichtempfindliche Bereiche der Lawinenphotodiodenelemente 24 und einzelnen oder Gruppen von Lawinenphotodiodenelementen 24 zugeordnete Schaltkreise zu deren Auswertung und Ansteuerung teilen.

Außerdem ist die optische Anordnung mit einem Lichtsender 12, der einen kleinen Anteil des Lichtempfängers 22 verdeckt, rein beispielhaft. Alternativ sind auch andere bekannte optische Lösungen einsetzbar, wie Autokollimation etwa mit einem Strahlteiler und einer gemeinsamen Optik, oder Pupillenteilung, wo zwei getrennte Optiken vorgesehen sind und Lichtsender und Lichtempfänger nebeneinander angeordnet werden.

Auch der dargestellte einstrahlige Sensor 10 insgesamt ist nur als Beispiel zu verstehen. Eine Erweiterung des Überwachungsbereichs 16 ist durch Bewegen des Strahls in einem Laserscanner möglich, sei es durch einen Drehspiegel oder einen insgesamt drehenden Messkopf mit Lichtsender 12 und/oder Lichtempfänger 22. So können mehrere einstrahlige Systeme kombiniert werden, um ein Lichtgitter mit mehreren, meist parallelen Strahlen zu bilden, welches insbesondere als tastendes Lichtgitter in jedem Strahl Entfernungen misst oder überwacht. Es kann mit den Lawinenphotodiodenelementen 24 einzeln oder gruppenweise ortsaufgelöst gemessen werden, so dass eine 3D-Kamera entsteht. Auch mobile Systeme sind denkbar, bei denen der Sensor 10 beweglich montiert ist.

Figur 2 zeigt übereinander drei Darstellungen des Zeitverlaufs eines kumulierten Empfangssignals der Lawinenphotodiodenelemente 24 im Bereich eines starken Empfangspulses. Dazu ist die Anzahl der auslösenden Lawinenphotodiodenelemente 24 gegen die Zeit aufgetragen. Im oberen Teil der Figur 2 ist der gesamte Empfangspuls, im mittleren Teil ein nicht mehr empfangener hinterer Rest des Empfangspulses und im unteren Teil komplementär der empfangene Anfangsbereich des Empfangspulses gezeigt.

Bei einem starken Empfangspuls lösen nämlich bereits dessen Photonen aus einem Anfangsbereich sämtliche verfügbaren Lawinenphotodiodenelemente 24 aus, so dass der gesamte Lichtempfänger 22 effektiv in Sättigung geht. Während des Auftreffens des hinteren Teils des Empfangspulses befinden sich dann alle oder nahezu alle Lawinenphotodiodenelemente 24 in ihrer Totzeit und können nicht mehr auf die Photonen des restlichen Empfangspulses reagieren.

Nun ist bei einer realen Messung die Pulsform nicht so sauber aufgelöst und abgeschnitten wie im unteren Teil der Figur 2, so dass eine Bestimmung des Empfangszeitpunkts nicht einfach auf den dort unverschobenen Maximalwert abstellen kann. Vielmehr kommt es bei einer realistischen Lichtlaufzeitmessung, die beispielsweise den Schwerpunkt bestimmt, zu einer fehlerhaften Pulsrekonstruktion. Das führt zu einem Fehler der Laufzeitmessung, der von der Intensität des Empfangspulses und der Totzeit der Lawinenphotodiodenelemente 24 abhängt. Dieser systematische Fehler ist eine besondere Ausprägung der für Lichtlaufzeitmessungen lange bekannten Schwarz-Weiß-Verschiebung beziehungsweise des intensitätsabhängigen Hell-Dunkel-Fehlers, wonach helle Objekte 18 in einer anderen Entfernung gemessen werden als dunkle Objekte 18, nun im Falle von Lawinenphotodiodenelementen 24 im Geiger-Modus.

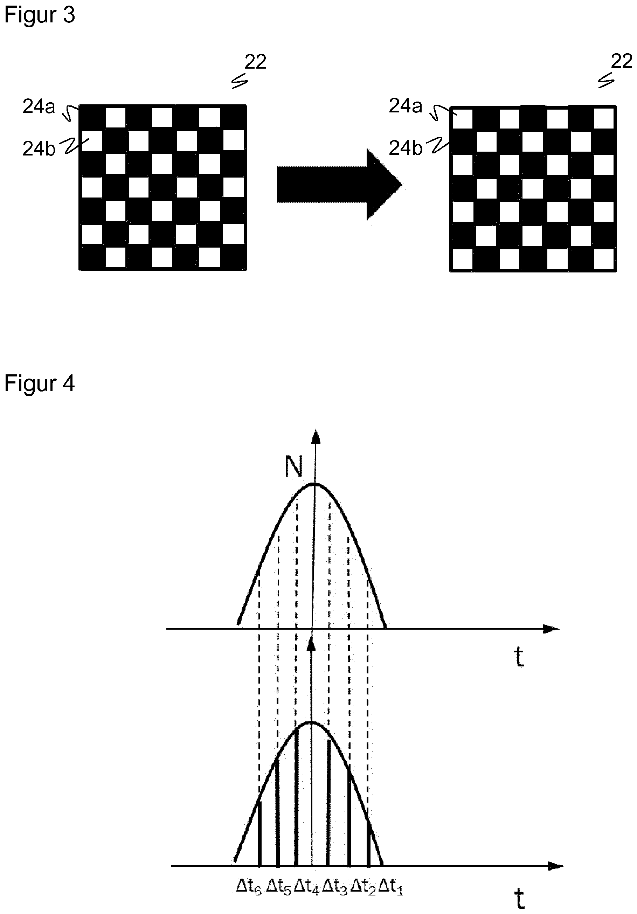

Eine mögliche Anwendung einer gruppenweisen Einstellung von Empfindlichkeiten der Lawinenphotodiodenelemente 24 in zeitlicher Abfolge mittels der Ansteuereinheit 30 ist, diesen systematischen Fehler zu vermeiden und eine intensitätsunabhängige, korrekte Rekonstruktion des Empfangspulses zu ermöglichen. Dazu werden nun vorbereitend unter Bezugnahme auf die Figuren 3-6 Beispiele erläutert, die in dieser Form wegen der zentralen Ansteuerungseinheit 30 nicht in den Schutzbereich der Ansprüche fallen.

Dazu sind in einem ersten Beispiel gemäß Figur 3 zwei alternierende Gruppen von Lawinenphotodiodenelementen 24a-b gebildet, die auf dem Lichtempfänger 22 zu einem Schachbrettmuster angeordnet sind. Wie im linken Teil der Figur 3 gezeigt, sind zunächst die Lawinenphotodiodenelemente 24a der ersten Gruppe aktiv (schwarz) und die Lawinenphotodiodenelemente 24b der zweiten Gruppe inaktiv (weiß). Mit einem definierten zeitlichen Versatz wird die Konfiguration gewechselt, nun sind wie im rechten Teil der Figur 3 die Lawinenphotodiodenelemente 24b der zweiten Gruppe aktiv (schwarz) und die Lawinenphotodiodenelemente 24a der ersten Gruppe inaktiv (weiß). Diesen Wechsel kann die Ansteuereinheit 30 ein- oder mehrfach in regelmäßiger oder unregelmäßiger Abfolge vornehmen.

Trifft nun ein starker Empfangspuls auf den Lichtempfänger 22, so werden allenfalls sämtliche momentan aktiven Lawinenphotodiodenelemente 24a oder 24b ausgelöst und dadurch während der nachfolgenden Totzeit unempfindlich. Nach dem Wechsel steht immer noch die andere Gruppe von nun aktiven Lawinenphotodiodenelementen 24b oder 24a für eine Detektion bereit, die sich nicht in ihrer Totzeit befinden.

Das in Figur 3 gezeigte Schachbrettmuster ist nur ein einfaches Beispiel. Allgemein seien die n x m Lawinenphotodiodenelemente 24 des Lichtempfängers 22 mit einem Zahlenpaar (i,j), 1 ≤ i ≤ n, i ≤ j ≤ m eindeutig adressierbar. Nun werden l Zeitfenster Δtk, 1 ≤ k ≤ l jeweils beliebiger Länge bestimmt, und zu jedem Zeitfenster Δtk wird eine Matrix mit Koeffizienten aₖ(i,j) für die Empfindlichkeit des Lawinenphotodiodenelements 24 an der Position (i,j) vorgegeben. Die Koeffizienten a(i,j) sind vorzugsweise zwischen einer minimalen und maximalen Empfindlichkeit normiert und nehmen wahlweise nur die digitalen Werte (0,1) für aktiv und inaktiv oder Zwischenwerte für Empfindlichkeiten dazwischen an. Solche Zwischenwerte werden bei Lawinenphotodiodenelementen 24 vorzugsweise mittels des Werts einer Überspannung oberhalb der Durchbruchspannung eingestellt. Beispielsweise steht der Wert 0 für unterhalb der Durchbruchspannung und der Wert 1 für eine komfortable Arbeitsspannung deutlich über der Durchbruchspannung, deren weitere Steigerung die Empfindlichkeit kaum noch verändern würde. Für Werte zwischen 0 und 1 wird die Überspannung entsprechend skaliert.

Auf die zuletzt beschriebene Weise werden in jedem Zeitfenster Δtk neue Gruppen von Lawinenphotodioden 24 gebildet, die im Extremfall jeweils nur aus einer Lawinenphotodiode 24 bestehen. Vorzugsweise werden für ein übersichtlicheres Vorgehen nur einige Gruppen gebildet, deren Gruppenzugehörigkeit bleibt über die Zeit erhalten, und es wird nur die Empfindlichkeit der Lawinenphotodiodenelemente 24 einer Gruppe zu bestimmten Zeitpunkten verändert. Zwar bietet eine Einzelansteuerung die größte Flexibilität, aber der Aufwand insbesondere für die zusätzlichen Leitungen zu jedem Lawinenphotodiodenelement 24 ist hoch und reduziert den Füllfaktor. Bei fester Gruppenzugehörigkeit dagegen können gemeinsame Ansteuerungen und Leitungen verwendet werden.

Figur 4 illustriert ein weiteres Beispiel. Gezeigt ist nochmals ein Empfangspuls ähnlich wie in der Figur 2. Das Zeitfenster der erwarteten Dauer des Empfangspulses wird unterteilt, hier beispielhaft regelmäßig und in sechs Teilabschnitte Δt1-Δt6. In jedem dieser Zeitfenster Δt1-Δt6 wird jeweils eine andere von sechs Gruppen von Lawinenphotodiodenelementen 24 aktiviert, so dass über die gesamte Dauer des Empfangspulses eine Population von detektionsbereiten Lawinenphotodiodenelementen 24 zur Verfügung steht, in denen noch kein Lawinendurchbruch ausgelöst wurde und die sich nicht in ihrer Totzeit befinden. Das gemeinsame Auslösen bei hoher Lichtlast beziehungsweise hohen Intensitätsgradienten wie in Figur 2 wird so vermieden. Der aus dem Empfangssignal der Lawinenphotodiodenelemente 24 rekonstruierte elektrische Empfangspuls hat keinen verschobenen Schwerpunkt, vielmehr ist dessen Pulsform wirklichkeitsgetreu nachgebildet und damit der Schwarz-Weiß-Fehler unterdrückt.

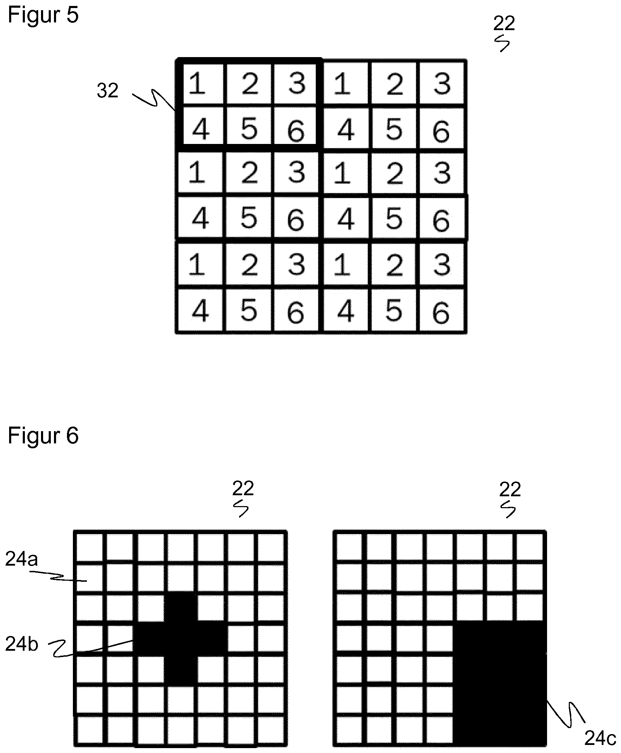

Figur 5 zeigt eine passende mögliche Verteilung der zu den Teilabschnitten Δt1-Δt6 gebildeten Gruppen von Lawinenphotodiodenelementen 24 auf dem Lichtempfänger 22. Dabei ist der Lichtempfänger 22 in ein regelmäßiges Raster aus Rasterelementen 32 unterteilt, von denen in Figur 5 nur eines exemplarisch durch eine dickere Linie hervorgehoben ist. Innerhalb jedes Rasterelements 32 ist mindestens ein Lawinenphotodiodenelement 24 jeder Gruppe vorgesehen, wie durch Ziffern 1...6 symbolisiert. Im Teilabschnitt Δt1 sind somit die Lawinenphotodiodenelemente 24 bei Ziffer 1 aktiv, und entsprechend für die weiteren Teilabschnitte Δt2-Δt6 die Lawinenphotodiodenelemente 24 bei Ziffer 2...6. Abweichend wäre denkbar, die Anordnung der durch die Ziffern 1...6 symbolisierten Gruppen über die Rasterelemente 32 zu variieren. Im Übrigen kann das durch Figur 5 illustrierte Beispiel als Verallgemeinerung des in Figur 3 illustrierten Beispiels mit einem Schachbrettmuster von zwei auf sechs und analog eine andere Anzahl von Gruppen verstanden werden.

Die Dauer der Teilabschnitte Δt1-Δt6 addiert sich vorteilhafterweise in etwa zu der erwarteten Dauer des Empfangspulses. Die einzelnen Dauern Δt1-Δt6 und die Abfolge können gleichmäßig sein, aber auch variiert werden. Auch ein zeitlicher Überlapp wäre denkbar, bei dem mindestens eine Gruppe noch aktiv ist, während schon die nächste Gruppe aktiviert wird. Die Ansteuersequenz wird vorzugsweise nach einem beliebigen periodischen Muster wiederholt, um eine unbekannte zeitliche Lage des Empfangspulses abzudecken, und sie kann mit dem Sendezeitpunkt des Lichtsignals 14 synchronisiert werden.

Die gewählte Anzahl von sechs Teilabschnitten Δt1- Δt6 beziehungsweise sechs Gruppen ist nur ein Beispiel. Es ist aber sinnvoll, nicht zu viele Gruppen und insbesondere höchstens zehn Gruppen zu bilden, damit in jeder Gruppe noch eine ausreichende Anzahl von Lawinenphotodiodenelementen 24 enthalten ist. Andernfalls würde ein schwächerer Empfangspuls von einem fernen und/oder dunklen Objekt 18 mit zu wenigen Lawinenphotodiodenelementen 24 möglicherweise gar nicht mehr erfasst, zumal typischerweise ein Empfangslichtfleck aus dem Fernbereich nur einen kleinen Teil des Lichtempfängers 22 beleuchtet und somit die meisten Lawinenphotodiodenelemente 24 selbst bei höchster Empfindlichkeit gar keine Nutzlichtphotonen empfangen. Ein kleiner Empfangslichtfleck aus dem Fernbereich lässt sich aber auch durch eine homogenisierende Optik vermeiden, wie etwa in der DE 10 2014 102 420 A1 beschrieben, wodurch möglichst der ganze Lichtempfänger 22 entfernungsunabhängig gleichmäßig ausgeleuchtet wird.

Bei der Auslegung der konkreten Aktivierungssequenz und der Anordnung von Lawinenphotodiodenelemente 24 zu Gruppen für eine bestimmte Anwendung werden vorzugsweise diese Parameter beachtet: Der Photonenstrom, die Anzahl der insgesamt verfügbaren Lawinenphotodiodenelemente 24, deren Photonen-Detektions-Effizienz (PDE) und deren Totzeit.

Figur 6 illustriert noch einmal, dass für eine solche Auslegung nicht nur die konkret beschriebenen gerasterten oder schachbrettartigen Muster zur Verfügung stehen, sondern prinzipiell auch beliebige Anordnungen. Wie in Figur 3 sind dabei die zum betrachteten Zeitpunkt aktiven Lawinenphotodiodenelemente 24 schwarz, die inaktiven Lawinenphotodiodenelemente 24 weiß dargestellt. Es kann auch Lawinenphotodiodenelemente 24 geben, die zu keiner Gruppe gehören und die immer aktiv, immer inaktiv oder immer auf eine bestimmte Empfindlichkeit eingestellt sind. Andererseits müssen solche Lawinenphotodiodenelemente 24 gar nicht gesondert betrachtet werden, indem man sie als weitere Gruppe auffasst, die zum Zeitpunkt Null etwa mit dem Einschalten auf die gewünschte Empfindlichkeit gesetzt werden.

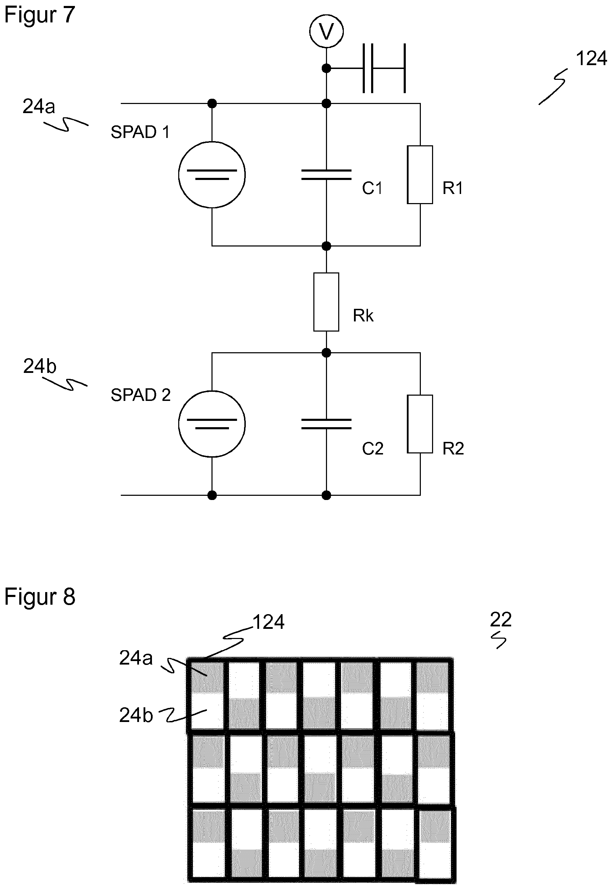

Figur 7 zeigt eine Prinzipschaltung zu einer vorteilhaften Ausführungsform. Dabei sind jeweils zwei Lawinenphotodiodenelemente 24a-b gemeinsam zu einer dualen Lawinenphotodiode 124 verschaltet, und zwar so, dass die Auslösung eines Lawinendurchbruchs in dem einen Lawinenphotodiodenelement 24a-b mit einem wählbaren Zeitversatz eine Änderung der Empfindlichkeit, insbesondere Aktivierung oder Deaktivierung des anderen Lawinenphotodiodenelements 24b-a zur Folge hat. Die gezeigten Schaltelemente sind gleichsam die ganz oder teilweise in die duale Lawinenphotodiode 124 integrierte Ansteuereinheit 30, die den Zeitpunkt für einen Wechsel der Empfindlichkeit dynamisch aus einem Lawinendurchbruch ableitet. Die beiden Lawinenphotodiodenelemente 24a-b teilen sich vorteilhafterweise einen Ladewiderstand Rk.

Die beiden Lawinenphotodiodenelemente 24a-b werden teilweise auch als vorderes Lawinenphotodiodenelement 24a und hinteres Lawinenphotodiodenelement 24b bezeichnet. Das ist aber nur eine sprachliche Vereinfachung, die sich an der zeitlichen Abfolge in einer bevorzugten Ausführungsform orientiert. In anderen Ausführungsformen kann auch das hintere Lawinenphotodiodenelemente 24b zuerst aktiv sein und das vordere Lawinenphotodiodenelement 24a aktivieren, das eine Lawinenphotodiodenelement 24a-b die Aktivität des anderen Lawinenphotodiodenelements 24b-a vorübergehend unterdrücken, oder es sind beide Lawinenphotodiodenelemente 24a-b gleichzeitig mit gleichen oder unterschiedlichen Empfindlichkeiten aktiv, wobei sich die Empfindlichkeit des Partner nach einem Lawinenausbruch gezielt verändert.

Die Prinzipschaltung der Figur 7 soll mit einem Zahlenbeispiel erläutert werden. Bei einer angenommenen Durchbruchspannung von 28 V stehen als gemeinsame Versorgungsspannung V 57 V zur Verfügung. Dies wird über die von den Widerständen R1 und R2 gebildete Spannungsteilerschaltung ungleich verteilt, nämlich 30 V oberhalb der Durchbruchspannung für das vordere Lawinenphotodiodenelement 24a und 27 V unterhalb der Durchbruchspannung für das hintere Lawinenphotodiodenelement 24b. Passende Werte für die Widerstände könnten R1=300K und R2=270K sein.

Wird nun die duale Lawinenphotodiode 124 beleuchtet, so reagiert darauf nur das vordere Lawinenphotodiodenelement 24a, das oberhalb der Durchbruchspannung vorgespannt ist, denn das hintere Lawinenphotodiodenelement 24b arbeitet nicht im Geiger-Modus und ist im relativen Vergleich als inaktiv anzusehen. Wegen des Lawinendurchbruchs in dem vorderen Lawinenphotodiodenelement 24a wird es niederohmig, und deshalb steigt der Spannungsabfall über dem hinteren Lawinenphotodiodenelement 24b an, treibt dessen Vorspannung über die Durchbruchspannung und steuert es so in den Geiger-Modus beziehungsweise aktiviert es.

Andere Zahlenwerte für die Widerstände R1 und R2, somit ein anderes Spannungsteilerverhältnis, und für die gemeinsame Versorgungsspannung führen wahlweise zu unterschiedlichen Überspannungen und damit Empfindlichkeiten, etwa um einen größeren Dynamikbereich abzubilden. Ein Lawinendurchbruch in dem einen Lawinenphotodiodenelement 24a-b macht dann das andere Lawinenphotodiodenelement 24b-a durch höhere Überspannung noch empfindlicher. Durch Modifikation der Verschaltung gemäß Figur 7 kann erreicht werden, dass ein Lawinendurchbruch in dem einen Lawinenphotodiodenelement 24a-b das andere Lawinenphotodiodenelement 24b-a stattdessen unempfindlicher macht oder sogar inaktiv setzt. Damit wird sozusagen das eine Lawinenphotodiodenelement 24a-b durch den Lawinendurchbruch des anderen Lawinenphotodiodenelements 24b-a gerade bei starkem Lichteinfall vorübergehend geschützt, damit danach während der Totzeit noch ein detektionsfähiges Lawinenphotodiodenelement 24a-b verbleibt.

Figur 8 zeigt eine beispielhafte, schachbrettartige Anordnung von dualen Lawinenphotodioden 124. Dabei steht sozusagen jede zweite Lawinenphotodiode 124 auf dem Kopf. Ansonsten würde sich ein Streifenmuster ergeben, was alternativ denkbar ist, denn die jeweilige Ortsabweichung um maximal die Ausdehnung eines Lawinenphotodiodenelements 24a-b ist gering. Mit diesem Prinzip eines Musters durch duale Lawinenphotodioden 124 wird in jedem Fall eine zeitliche Abfolge der Aktivität ohne externe Ansteuerung ermöglicht, so dass insbesondere die oben genannten Vorteile einer verbesserten Rekonstruktion eines Empfangspulses und letztlich die Kompensation eines Hell-Dunkel-Fehlers auf besonders einfachem Weg erreicht wird. Die vorderen Lawinenphotodiodenelemente 24a und die hinteren Lawinenphotodiodenelemente 24b bilden dabei jeweils eine von zwei Gruppen, ähnlich wie in Figur 3, mit dem Unterschied, dass in den dualen Lawinenphotodioden 124 die jeweiligen hinteren Lawinenphotodioden 24b nicht gemeinsam als eine Gruppe, sondern individuell auf einen Lawinendurchbruch hin aktiviert werden.

Das in Figur 8 gezeigte Muster ist nur ein Beispiel. Abgesehen von anderen Anordnungen ist auch eine Kombination mit einzelnen, nicht dualen Lawinenphotodiodenelementen 24 denkbar, die insbesondere Gruppen bilden, wie oben zu den Figuren 2 bis 6 beschrieben. Das Konzept einer dualen Verschaltung zweier Lawinenphotodiodenelemente 24a-b kann auch auf k-fach-Lawinenphotodioden, k ≥ 3, ausgedehnt werden. Eine weitere Variationsmöglichkeit besteht darin, unterschiedliche Lawinenphotodiodenelemente 24a-b etwa mit verschieden großen lichtempfindlichen Flächen zu einer dualen Lawinenphotodiode 124 zu verschalten.

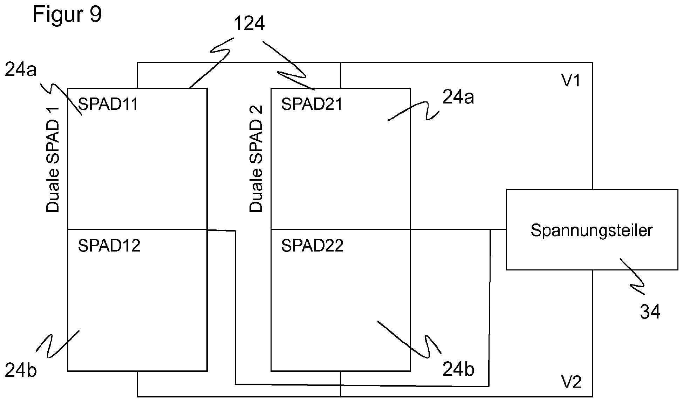

Figur 9 zeigt ein Beispiel für eine Parallelschaltung mehrerer paralleler dualer Lawinenphotodioden 124. Bei Bedarf kann abweichend jede zweite duale Lawinenphotodiode 124 auf den Kopf gestellt werden. Im Gegensatz zu Figur 7 wird hier die Vorspannung nicht individuell pro dualer Lawinenphotodiode 124 auf die jeweiligen beiden Lawinenphotodiodenelemente 24a-b verteilt. Stattdessen sind mehrere duale Lawinenphotodioden 124 parallel geschaltet, insbesondere alle dualen Lawinenphotodioden 124 einer Zeile oder Spalte, und werden über einen gemeinsamen Spannungsteiler 34 versorgt. Der Spannungsteiler 34 kann alternativ so ausgelegt werden, dass die beiden Lawinenphotodiodenelemente 24a-b einander in umgekehrter Reihenfolge triggern, so dass die duale Lawinenphotodiode 124 quasi "auf dem Kopf steht". In einer Anordnung einer Vielzahl dualer Lawinenphotodioden 124 können solche "auf dem Kopf stehenden" und "nicht auf dem Kopf stehenden" dualen Lawinenphotodioden 124 beliebig mischen.

Zudem ist vorzugsweise das Spannungsteilerverhältnis variabel, um beispielsweise die Lawinenphotodiodenelemente 24a-b mit verschiedenen Überspannungen und einer Spannung unterhalb der Durchbruchspannung vorzuspannen. Bei einer weiterhin rein beispielhaft angenommenen Durchbruchspannung von 28 V könnte der Variationsbereich bei 26 V ... 35 V oder mehr liegen. Dadurch kann die gewünschte Empfindlichkeit beziehungsweise die zeitliche Verzögerung zwischen Lawinendurchbruch und Aktivierung des Partners in der dualen Lawinenphotodiode 124 von außen angesteuert werden. Eine variable beziehungsweise von außen veränderbare Einstellung des Spannungsteilerverhältnisses ist auch ohne Parallelschaltung mehrerer dualer Lawinenphotodioden 124 nur für eine einzelne duale Lawinenphotodiode 124 wie in Figur 7 denkbar.

Die dualen Lawinenphotodioden 124 können bei Verwendung einer geeigneten Ausleseschaltung, wie sie etwa in EP 3 124 992B1 vorgestellt wird, auch bei hohen Frequenzen bis in den Gigahertzbereich hinein betrieben werden.

## Patentansprüche

1. Lichtempfänger (22) mit einer Vielzahl von Lawinenphotodiodenelementen (24a, 24b), die jeweils mit einer Vorspannung oberhalb einer Durchbruchspannung vorspannbar und somit in einem Geiger-Modus betreibbar sind, wobei die Lawinenphotodiodenelemente (24a, 24b) mehrere Gruppen bilden und wobei jeweils zwei Lawinenphotodiodenelemente (24a, 24b) aus zwei unterschiedlichen Gruppen eine mindestens duale Lawinenphotodiode (124) mit mindestens einem vorderen Lawinenphotodiodenelement (24a) und einem hinteren Lawinenphotodiodenelement (24b) bilden, bei der ein Lawinendurchbruch des vorderen Lawinenphotodiodenelements (24a) die Empfindlichkeit des hinteren Lawinenphotodiodenelements (24b) verändert oder umgekehrt,
**dadurch gekennzeichnet, dass**
der dualen Lawinenphotodiode (124) eine Verschaltungseinheit (V, R1, R2, 34) zugeordnet ist, welche im Ruhezustand vor einem Lawinendurchbruch das vordere Lawinenphotodiodenelement (24a) auf eine Vorspannung über und das hintere Lawinenphotodiodenelement (24b) auf eine Vorspannung unter der Durchbruchspannung hält oder umgekehrt.

2. Lichtempfänger (22) nach einem der vorhergehenden Ansprüche, wobei eine Lichtlaufzeitmesseinheit (28) vorgesehen ist, die dafür ausgebildet ist, aus den Signalen der Lawinenphotodiodenelemente (24a, 24b) eine Lichtlaufzeit eines Lichtpulses zu bestimmen.

3. Lichtempfänger (22) nach einem der vorhergehenden Ansprüche, wobei die Lawinenphotodiodenelemente (24a, 24b) eine Matrixanordnung bilden, und wobei in einer Unterteilung der Matrixanordnung in ein Raster aus Rasterelementen (32) jede Gruppe mindestens ein Lawinenphotodiodenelement (24a, 24b) in jedem Rasterelement (32) aufweist.

4. Lichtempfänger (22) nach einem der vorhergehenden Ansprüche, wobei die Lawinenphotodiodenelemente (24a, 24b) zweier Gruppen ein Schachbrettmuster bilden.

5. Lichtempfänger (22) nach einem der vorhergehenden Ansprüche, wobei der Lawinendurchbruch des vorderen Lawinenphotodiodenelements (24a) für eine veränderte Vorspannung an dem hinteren Lawinenphotodiodenelement (24b) sorgt oder umgekehrt.

6. Lichtempfänger (22) nach einem der vorhergehenden Ansprüche,
wobei die Verschaltungseinheit eine Spannungsteilerschaltung (R1, R2, 34) aufweist.

7. Lichtempfänger (22) nach einem der vorhergehenden Ansprüche,
wobei eine Verzögerungsschaltung vorgesehen ist, welche nach einem Lawinendurchbruch in dem vorderen Lawinenphotodiodenelement (24a) das hintere Lawinenphotodiodenelement (24b) nach einer vorgebbaren Verzögerungszeit aktiviert oder deaktiviert oder umgekehrt.

8. Optoelektronischer Sensor (10) mit mindestens einem Lichtempfänger (22) nach einem der vorhergehenden Ansprüche, wobei der Sensor (10) insbesondere ein entfernungsmessender Sensor (10) mit einem Lichtsender (12) zum Aussenden eines Lichtsignals (14) und mit einer Lichtlaufzeitmesseinheit (28) ist, die dafür ausgebildet ist, aus einer Lichtlaufzeit zwischen Aussenden des Lichtsignals (14) und Empfangen des von einem Objekt (18) aus einem Überwachungsbereich (16) remittierten Lichtsignals (20) einen Abstand des Objekts (18) zu bestimmen.

9. Verfahren zum Erfassen von Licht (20) mit einer Vielzahl von Lawinenphotodiodenelementen (24a, 24b), die jeweils zumindest phasenweise mit einer Vorspannung oberhalb einer Durchbruchspannung vorgespannt und somit in einem Geiger-Modus betrieben werden, wobei die Lawinenphotodiodenelemente (24a, 24b) mehrere Gruppen bilden und die Empfindlichkeit der Lawinenphotodiodenelemente (24) verändert wird, und wobei
jeweils zwei Lawinenphotodiodenelemente (24a, 24b) aus zwei unterschiedlichen Gruppen eine mindestens duale Lawinenphotodiode (124) mit mindestens einem vorderen Lawinenphotodiodenelement (24a) und einem hinteren Lawinenphotodiodenelement (24b) bilden, bei der ein Lawinendurchbruch des vorderen Lawinenphotodiodenelements (24a) die Empfindlichkeit des hinteren Lawinenphotodiodenelements (24b) verändert oder umgekehrt,
**dadurch gekennzeichnet, dass** eine der dualen Lawinenphotodiode (124) zugeordnete Verschaltungseinheit (V, R1, R2, 34) im Ruhezustand vor einem Lawinendurchbruch das vordere Lawinenphotodiodenelement (24a) auf eine Vorspannung über und das hintere Lawinenphotodiodenelement (24b) auf eine Vorspannung unter der Durchbruchspannung hält oder umgekehrt.

## Claims

1. A light receiver (22) comprising a plurality of avalanche photodiode elements (24a, 24b) each biasable at a bias voltage above a breakdown voltage and thus operable in a Geiger mode, wherein the avalanche photodiode elements (24a, 24b) form a plurality of groups and wherein two avalanche photodiode elements (24a, 24b) each from two different groups form an at least dual avalanche photodiode (124) with at least one front avalanche photodiode element (24a) and one rear avalanche photodiode element (24b), an avalanche breakthrough of the front avalanche photodiode element (24a) changing the sensitivity of the rear avalanche photodiode element (24b) or vice versa,
**characterized in that** a circuit unit (V, R1, R2, 34) is associated with the dual avalanche photodiode (124) which, in a rest state prior to an avalanche breakdown, keeps the front avalanche photodiode element (24a) at a bias voltage above and the rear avalanche photodiode element (24b) at a bias voltage below the breakdown voltage or vice versa.

2. The light receiver (22) according to any of the preceding claims,
wherein a light time of flight measuring unit (28) is provided which is configured to determine a light time of flight of a light pulse from the signals of the avalanche photodiode elements (24a, 24b).

3. The light receiver (22) according to any of the preceding claims,
wherein the avalanche photodiode elements (24a, 24b) form a matrix array, and wherein, in a subdivision of the matrix array into a grid of grid elements (32), each group comprises at least one avalanche photodiode element (24a, 24b) in each grid element (32).

4. The light receiver (22) according to any of the preceding claims,
wherein the avalanche photodiode elements (24a, 24b) of two groups form a checkerboard pattern.

5. The light receiver (22) according to any of the preceding claims,
wherein the avalanche breakthrough of the front avalanche photodiode element (24a) provides for a changed bias at the rear avalanche photodiode element (24b) or vice versa.

6. The light receiver (22) according to any of the preceding claims,
wherein the circuit unit comprises a voltage divider circuit (R1, R2, 34).

7. The light receiver (22) according to any of the preceding claims,
wherein a delay circuit is provided which, after an avalanche breakthrough in the front avalanche photodiode element (24a), activates or deactivates the rear avalanche photodiode element (24b) after a predeterminable delay time or vice versa.

8. An optoelectronic sensor (10) having at least one light receiver (22) according to any of the preceding claims, wherein the sensor (10) is in particular a distance-measuring sensor (10) having a light transmitter (12) for transmitting a light signal (14) and having a light time of flight measuring unit (28) which is configured to determine a distance of the object (18) from a light time of flight between transmission of the light signal (14) and reception of the light signal (20) remitted by an object (18) from a monitoring region (16).

9. A method for detecting light (20) with a plurality of avalanche photodiode elements (24a, 24b) which are each biased at least in phases with a bias voltage above a breakdown voltage and are thus operated in a Geiger mode, the avalanche photodiode elements (24a, 24b) forming a plurality of groups and the sensitivity of the avalanche photodiode elements (24) being varied, and wherein two avalanche photodiode elements (24a, 24b) each from two different groups form an at least dual avalanche photodiode (124) having at least one front avalanche photodiode element (24a) and one rear avalanche photodiode element (24b), an avalanche breakdown of the front avalanche photodiode element (24a) changing the sensitivity of the rear avalanche photodiode element (24b) or vice versa,
**characterized in that** a circuit unit (V, R1, R2, 34) associated with the dual avalanche photodiode (124), in a rest state prior to an avalanche breakdown, keeps the front avalanche photodiode element (24a) at a bias voltage above and the rear avalanche photodiode element (24b) at a bias voltage below the breakdown voltage or vice versa.

## Revendications

1. Récepteur de lumière (22) comprenant une pluralité d'éléments de photodiode à avalanche (24a, 24b) pouvant chacun être polarisé à une tension de polarisation supérieure à une tension de claquage et pouvant ainsi fonctionner dans un mode Geiger, dans lequel les éléments de photodiode à avalanche (24a, 24b) forment une pluralité de groupes et dans lequel deux éléments de photodiode à avalanche (24a, 24b) provenant chacun de deux groupes différents forment une photodiode à avalanche au moins double (124) avec au moins un élément de photodiode à avalanche avant (24a) et un élément de photodiode à avalanche arrière (24b), un claquage en avalanche de l'élément de photodiode à avalanche avant (24a) modifiant la sensibilité de l'élément de photodiode à avalanche arrière (24b) ou vice versa,
**caractérisé en ce qu'**une unité de circuit (V, R1, R2, 34) est associée à la double photodiode à avalanche (124) qui, dans un état de repos avant un claquage en avalanche, maintient l'élément de photodiode à avalanche avant (24a) à une tension de polarisation supérieure à la tension de claquage et l'élément de photodiode à avalanche arrière (24b) à une tension de polarisation inférieure à la tension de claquage ou vice versa.

2. Récepteur de lumière (22) selon l'une des revendications précédentes,
dans lequel une unité de mesure du temps de vol de la lumière (28) est prévue qui est configurée pour déterminer un temps de vol de la lumière d'une impulsion lumineuse à partir des signaux des éléments de photodiode à avalanche (24a, 24b).

3. Récepteur de lumière (22) selon l'une des revendications précédentes,
dans lequel les éléments de photodiode à avalanche (24a, 24b) forment un réseau matriciel, et dans lequel, lors d'une subdivision du réseau matriciel en une grille d'éléments de grille (32), chaque groupe comprend au moins un élément de photodiode à avalanche (24a, 24b) dans chaque élément de grille (32).

4. Récepteur de lumière (22) selon l'une des revendications précédentes,
dans lequel les éléments de photodiode à avalanche (24a, 24b) de deux groupes forment un motif en damier.

5. Récepteur de lumière (22) selon l'une des revendications précédentes,
dans lequel le claquage en avalanche de l'élément de photodiode à avalanche avant (24a) permet de modifier la polarisation de l'élément de photodiode à avalanche arrière (24b) ou vice versa.

6. Récepteur de lumière (22) selon l'une des revendications précédentes,
dans lequel l'unité de circuit comprend un circuit diviseur de tension (R1, R2, 34).

7. Récepteur de lumière (22) selon l'une des revendications précédentes,
dans lequel un circuit de retardement est prévu qui, après un claquage en avalanche dans l'élément de photodiode à avalanche avant (24a), active ou désactive l'élément de photodiode à avalanche arrière (24b) après un temps de retard pouvant être prédéterminé ou vice versa.

8. Capteur optoélectronique (10) avec au moins un récepteur de lumière (22) selon l'une des revendications précédentes, le capteur (10) étant en particulier un capteur de mesure de distance (10) avec un émetteur de lumière (12) pour l'émission d'un signal lumineux (14) et avec une unité de mesure du temps de vol de la lumière (28) qui est configurée pour déterminer une distance de l'objet (18) à partir d'un temps de vol de la lumière entre l'émission du signal lumineux (14) et la réception du signal lumineux (20) émis par un objet (18) d'une zone de surveillance (16).

9. Procédé de détection de lumière (20) avec une pluralité d'éléments de photodiode à avalanche (24a, 24b) qui sont respectivement polarisés au moins en phase avec une tension de polarisation supérieure à une tension de claquage et qui fonctionnent ainsi dans un mode Geiger, les éléments de photodiode à avalanche (24a, 24b) formant une pluralité de groupes et la sensibilité des éléments de photodiode à avalanche (24) étant modifiée, et dans lequel deux éléments de photodiode à avalanche (24a, 24b) provenant chacun de deux groupes différents forment une photodiode à avalanche au moins double (124) ayant au moins un élément de photodiode à avalanche avant (24a) et un élément de photodiode à avalanche arrière (24b), un claquage en avalanche de l'élément de photodiode à avalanche avant (24a) modifiant la sensibilité de l'élément de photodiode à avalanche arrière (24b) ou vice versa,
**caractérisé en ce qu'**une unité de circuit (V, R1, R2, 34) associée à la double photodiode à avalanche (124), dans un état de repos avant un claquage en avalanche, maintient l'élément de photodiode à avalanche avant (24a) à une tension de polarisation supérieure et l'élément de photodiode à avalanche arrière (24b) à une tension de polarisation inférieure à la tension de claquage ou vice versa.
